# EUROPEAN PATENT APPLICATION

(11) **EP 1 821 324 A2**
(43) Date of publication of application: **22.08.2007**
(21) Application number: 07102565.4
(22) Date of filing: 16.02.2007
(51) Int. Cl.: H01G 9/20

(54) **Photoelectric transducer comprising Zn cytochrome c**

(30) Priority: 16.02.2006 JP 2006038874
(71) Applicant: Sony Corporation, Minato-ku Tokyo (JP)
(72) Inventor: Shimura, Jusuke, TOKYO (JP); Tokita, Yuichi, TOKYO (JP); Goto, Yoshio, TOKYO (JP)
(74) Representative: Thévenet, Jean-Bruno

(57) **Abstract**

A photoelectric transducer includes a first electrode (11), an electron transferring protein (12), and a second electrode (13). The first electrode (11) includes an electroconductive material. The electron transferring protein (12) is immobilized on or above the first electrode (11), has a photoelectric conversion capability, and contains a metal. The second electrode (13) includes an electroconductive material.

## Description

### BACKGROUND OF THE INVENTION

### 1. Field of the Invention

The present invention relates to photoelectric transducers, semiconductor devices, and electronic instruments. More specifically, it relates to photoelectric transducers, semiconductor devices, and electronic instruments each using photoelectric converting and electron transferring proteins as receivers for carrying out photoelectric conversion.

### 2. Description of the Related Art

Photoelectric transducers include those using inorganic semiconductors and those using organic semiconductors.

However, photoelectric transducers using inorganic semiconductors in related art use flat substrates, and it is difficult to form transducers on a curved surface having an arbitrary shape. In contrast, photoelectric transducers using organic semiconductors in related art may be prepared through complicated organic syntheses to yield organic semiconductors, although organic semiconductors can be arranged on a curved surface having an arbitrary shape.

Possible candidates for photoelectric transducers that can be formed even on a curved surface having an arbitrary shape include those using fluorescent proteins. There has been reported that, when zinc cytochrome c (Zn cytochrome c) is adsorbed at random by a nanoporous titanium oxide (TiO₂) electrode and is irradiated with light, an electron is excited and injected into a conduction band of titanium dioxide TiO₂, and thereby a photoelectric current flows ( Emmanuel Topoglidis, Colin J. Campbell, Emilio Palomares, and James R. Durrant, Chem. Commun. 2002, 1518-1519).

The occurrence of a photoelectric current upon irradiation with light has also been reported on a monomolecular film having a two-layer structure including iron cytochrome c (Fe cytochrome c) and green fluorescent protein (GFP) immobilized on or above a gold substrate (Jeong-Woo Choi and Masamichi Fujihira, Appl. Phys. Lett. 84, 2187-2189 (2004)).

In addition, Shiro Yasutomi, Tomoyuki Morita, Yukio Imanishi, and Shunsaku Kimura have reported that a photoelectric current occurs upon irradiation with light on a monomolecular film of a peptide immobilized on or above a gold substrate in Science 304, 1944-1947 (2004). In this technique, two peptides having different photoresponsivities are immobilized on or above one gold substrate with the interposition of a disulfide monomolecular film as a sulfur compound. The polarity of a photoelectric current is thereby controlled by varying the wavelength of applied light.

A method for preparing zinc cytochrome c has been reported (Martin Braun, Stefan Atalick, Dirk M. Guldi, Harald Lanig, Michael Brettreich, Stephan Burghardt, Maria Hatzimarinaki, Elena Ravanelli, Maurizio Prato, Rudi van Eldik, and Andreas Hirsch, Chem. Eur. J. 9, 3867-3875 (2003)).

A method for preparing a gold electrode which adsorbs a monomolecular film of iron cytochrome c can be found in a document (Ryutaro Tanimura, Michael G. Hill, Emanuel Margoliash, Katsumi Niki, Hiroyuki Ohno, and Harry Gray, Electrochem. Solid-State Lett. 5, E67-E70 (2002)).

### SUMMARY OF THE INVENTION

In the technique reported in Chem. Commun. 2002, 1518-1519, a photoelectric current is observed probably because zinc cytochrome c is adsorbed by TiO₂ electrode having a charge separation capability. Titanium dioxide (TiO₂), however, has a very high resistivity and acts as an insulator, and it is difficult to effectively extract a photoelectric current outside according to this technique. This configuration is therefore unsuitable as a photoelectric transducer.

The technique reported in Appl. Phys. Lett. 84, 2187-2189 (2004) uses a scanning tunneling microscope for the detection of a photoelectric current, and this fails to disclose a specific configuration of a photoelectric transducer. In addition, the photoelectric current observed herein does not show bidirectionality.

Under these circumstances, it is desirable to provide a photoelectric transducer which can be arranged even on a curved surface having an arbitrary shape, uses a photoelectric conversion material capable of easily preparing even without a complicated chemical synthesis, and yields a photoelectric current with bidirectionality. It is also desirable to provide a semiconductor device and an electronic instrument using the photoelectric transducer.

After intensive investigations, the present inventors first have succeeded to observe a photoelectric current of zinc cytochrome c upon optical excitation even without using a scanning tunneling microscope. A configuration to be observed herein includes a spherical gold electrode and a counter electrode, and the spherical gold electrode adsorbs a monomolecular film of zinc cytochrome c. They have found that both the polarity (direction of flow) and the magnitude of a photoelectric current can be controlled by regulating the potential difference between the spherical electrode and the counter electrode, and regulating the intensity of light applied to zinc cytochrome c on the spherical electrode. The term "potential difference between the spherical electrode and the counter electrode" includes both meanings of a bias voltage artificially formed by the application of a voltage, and the difference in spontaneous electrode potential between the spherical electrode and the counter electrode. They have also found that the polarity of a dark current, if occurring stationarily, can be reversed upon irradiation with light. These may be established not only in zinc cytochrome c but also in other electron transferring proteins having a photoelectric conversion capability and containing a metal.

The present inventors have made further investigations based on these findings.

According to one embodiment of the present invention, there is provided a photoelectric transducer which includes a first electrode including an electroconductive material; zinc cytochrome c, a derivative thereof, or a mutant of them immobilized on or above the first electrode; and a second electrode including an electroconductive material.

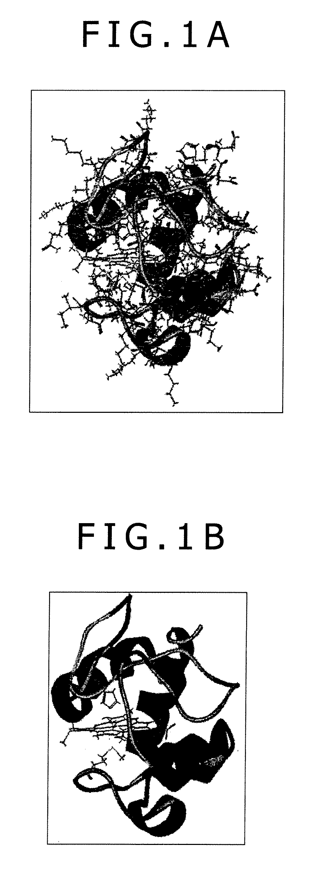

FIGS. 1A and 1B illustrate a ribbon model of zinc cytochrome c, with or without illustration of amino acid side chains, respectively. Zinc coordinates as a central metal on a porphyrin at the center of zinc cytochrome c, and this acts as the nucleus of optical absorption and photo-induced electron transfer reactions. A protein moiety of zinc cytochrome c surrounding porphyrin is an insulator. The zinc cytochrome c structurally includes porphyrin acting as the nucleus of electron transfer reaction and being sandwiched between thin insulators. This can be regarded as a kind of double-barrier tunneling junction element. Alternatively, the zinc cytochrome c can also be regarded as a kind of quantum dot, because it structurally includes porphyrin surrounded by a thin insulator. A quantum dot array element can be obtained by arraying such quantum dots one-dimensionally, two-dimensionally, or three-dimensionally. The zinc cytochrome c shows characteristic absorption peaks called as Soret band and Q-band in the visible ray region and can be optically excited or pumped upon irradiation with visible rays.

A "derivative of zinc cytochrome c" corresponds to zinc cytochrome c, except with one or more amino acid residues in its skeleton being chemically modified. A "mutant of zinc cytochrome c" corresponds to zinc cytochrome c, except for replacing part of amino acid residues in its skeleton with one or more other amino acid residues.

By combining zinc cytochrome c with one or more other electron transferring proteins such as iron cytochrome c, an electron formed as a result of optical excitation in zinc cytochrome c can be sequentially transferred through these electron transferring proteins to an end of the assemblage by the action of tunneling. In this case, the one or more electron transferring proteins combined with zinc cytochrome c act as an interconnection (wiring). Zinc cytochrome c may also be connected to one or more DNA interconnections.

Zinc cytochrome c, a derivative thereof, or a mutant of them (hereinafter also simply referred to as "zinc cytochrome c", unless otherwise specified) has a photoelectric conversion capability in addition to an electron transfer capability and thereby yields an electron as a result of optical excitation. In addition, zinc cytochrome c can promptly transfer the electron to the exterior and thereby yields a photoelectric current.

At least one molecule of, and generally a monomolecular film or multilayer film of zinc cytochrome c is immobilized on or above a first electrode including an electroconductive material. It is immobilized, for example, through an electrostatic bond or a chemical bond. It is also acceptable that two or more first electrodes are separately arranged on a substrate, and one or more molecules of zinc cytochrome c are immobilized to each of the first electrodes. Zinc cytochrome c may be immobilized on or above a first electrode directly or indirectly with the interposition of an intermediate layer. Such an intermediate layer may include, for example, an organic compound containing a heteroatom such as sulfur atom. The intermediate layer for use herein is preferably one that can prevent reverse electron transfer. In the reverse electron transfer, an electron formed as a result of optical excitation of zinc cytochrome c once moves to the first electrode and then returns to zinc cytochrome c again. In other words, the intermediate layer preferably has a rectification capability. Such an intermediate layer includes, for example, a monomolecular film of a disulfide as a sulfur compound (Shiro Yasutomi, Tomoyuki Morita, Yukio Imanishi, Shunsaku Kimura, Science 304, 1944-1947 (2004)). An electroconductive material for use in a first electrode is preferably one capable of excellently immobilizing zinc cytochrome c, if directly immobilized to the first electrode. It is preferably one capable of excellently immobilizing an intermediate layer, if zinc cytochrome c is immobilized on or above the first electrode with the interposition of the intermediate layer. Specifically, examples of such electroconductive materials are metals, electroconductive glass, electroconductive oxides, and electroconductive polymers. The first electrode may have a surface with any shape, such as a convex, a concave, or a convex-concave surface. Zinc cytochrome c can be easily immobilized on or above a surface with any shape or dimensions. An electroconductive material for use in a second electrode can be similar to those for use in the first electrode. At least one of the first and second electrodes is configured to be transparent to visible rays, when light is applied through the at least one of the first and second electrodes.

The photoelectric transducer may work either in a solution (electrolytic solution) or in a dry condition, as long as the photoelectric conversion capability and electron transfer capability of zinc cytochrome c are not adversely affected. When the transducer is operated in an electrolytic solution, the transducer may be typically so configured that the second electrode is arranged so as to face, at a spacing, the zinc cytochrome c immobilized on or above the first electrode, and that the first electrode and the second electrode are immersed in an electrolytic solution. An electrolyte (or a redox species) for use in the electrolytic solution may be one undergoing an oxidation reaction in the first electrode and undergoing a reducing reaction in the second electrode, or one undergoing a reducing reaction in the first electrode and undergoing an oxidation reaction in the second electrode. More specifically, the electrolyte or redox species includes, for example, K₄[Fe(CN)₆] and [Co(NH₃)₆]Cl₃. When the transducer is operated under a dry condition, the transducer may be typically so configured that a solid electrolyte that does not adsorb zinc cytochrome c is arranged between the second electrode and the zinc cytochrome c immobilized on or above the first electrode. More specifically, the solid electrolyte may be a wet solid electrolyte such as agar or polyacrylamide gel. More preferably, the transducer further includes a barrier wall around the solid electrolyte, so as to prevent the solid electrolyte from drying. According to such cases, a photoelectric current is obtained when a receiver including zinc cytochrome c receives light with a polarity based on the difference in spontaneous electrode potential between the first electrode and the second electrode.

When this photoelectric transducer is operated in an electrolytic solution, a porous electroconductive material may be used as a material for the first electrode on which zinc cytochrome c is immobilized. Such a porous electroconductive material has a large specific surface area to thereby yield a very large surface area of the entire electrode. Zinc cytochrome c can be immobilized three-dimensionally in a high density by immobilizing zinc cytochrome c on a porous electroconductive material, to thereby yield a large quantity of photoelectric current. Specific examples of the porous electroconductive material include metallic materials such as metals and alloys, and carbon materials strengthened in its skeleton, i.e., improved in its fragility. Among metal materials as porous electroconductive materials, easily available materials are foamed metals and foamed alloys including, for example, nickel, copper, silver, gold, nickel-chromium alloys, and stainless steels. The porosity and pore size (smallest diameter of pores) of the porous electroconductive material may be appropriately set in consideration of the size of zinc cytochrome c. More preferably, the porosity and pore size may be set so that light can reach the deepest portion of the electrode when viewed from the incident direction. The pore size is generally about 10 nm to 1 mm, and typically about 10 nm to about 600 µm. The porous electroconductive material preferably has pores all of which communicate with each other.

The photoelectric transducer can have a varied magnitude and/or polarity of a photoelectric current passing therethrough by regulating at least one of the potential difference between the first electrode and the second electrode; the intensity of light to be applied to zinc cytochrome c; and the wavelength of light to be applied to zinc cytochrome c. The term "potential difference between the first electrode and the second electrode" includes both meanings of a bias voltage artificially formed by the application of a voltage, and the difference in spontaneous electrode potential between the first electrode and the second electrode.

The photoelectric transducer according to the embodiment of the present invention can be used, for example, in photoelectric detectors (photosensers), where necessary, in combination with other components such as an amplifier circuit for amplifying a photoelectric current. Such photoelectric detectors can be used in a variety of uses such as detection of light information and can be applied typically to artificial retinas. A photoelectric transducer can also be used as a solar cell.

The photoelectric transducer can be used in devices and apparatuses using photoelectric conversion. More specifically, it can be used typically in electronic instruments having receivers.

According to another embodiment of the present invention, there is provided a semiconductor device which includes a photoelectric transducer, and the photoelectric transducer includes a first electrode including an electroconductive material; zinc cytochrome c, a derivative thereof, or a mutant of them immobilized on or above the first electrode; and a second electrode including an electroconductive material.

The semiconductor device may include a photoelectric transducer immobilized on or above a semiconductor substrate. The semiconductor substrate further typically includes semiconductor devices and electronic circuits for amplifying a photoelectric current taken out from the photoelectric transducer. Such components may be formed, for example, according to a semiconductor technology in related art. The semiconductor substrate can be a semiconductor substrate including an elemental semiconductor such as silicon (Si), or a semiconductor substrate including a compound semiconductor such as gallium arsenide (GaAs). The semiconductor device can be configured, for example, as an optoelectronic integrated circuit device. The optoelectronic integrated circuit device may further include other components on a semiconductor substrate, in addition to the photoelectric transducer. Such other components include, for example, light-emitting elements such as semiconductor laser and light-emitting diodes, and electronic circuits. In this case, the circuit device may be configured so that light from a light-emitting element enters the photoelectric transducer.

The semiconductor device may have any functions and may be used in any use. More specifically, it may be used, for example, as photoelectric detectors, optical signal processor, and image sensors such as MOS image sensors and charge transfer devices (CTD), and charge-coupled devices (CCD).

Other configurations as described above may be adopted herein, unless contrary to properties thereof.

According to yet another embodiment of the present invention, there is provided a photoelectric transducer which includes a first electrode including an electroconductive material; an electron transferring protein being immobilized on or above the first electrode, having a photoelectric conversion capability, and containing a metal; and a second electrode including an electroconductive material.

According to still another embodiment of the present invention, there is provided a semiconductor device which includes a photoelectric transducer, in which the photoelectric transducer includes a first electrode including an electroconductive material; an electron transferring protein being immobilized on or above the first electrode, having a photoelectric conversion capability, and containing a metal; and a second electrode including an electroconductive material.

Electron transferring proteins having a photoelectric conversion capability and containing a metal for use herein include, for example, zinc cytochrome c and other cytochromes c, as well as ferredoxin, rubredoxins, plastocyanin, azurin, pseudoazurin, and stellacyanin.

Other configurations as described above may be adopted herein, unless contrary to properties thereof.

According to an embodiment of the present invention, there is provided an electronic instrument which includes one or more photoelectric transducers, in which at least one of the one or more photoelectric transducers is a photoelectric transducer including a first electrode including an electroconductive material; zinc cytochrome c, a derivative thereof, or a mutant of them immobilized on or above the first electrode; and a second electrode including an electroconductive material.

According to another embodiment of the present invention, there is also provided an electronic instrument which includes one or more photoelectric transducers, in which at least one of the one or more photoelectric transducers is a photoelectric transducer including a first electrode including an electroconductive material; an electron transferring protein being immobilized on or above the first electrode, having a photoelectric conversion capability, and containing a metal; and a second electrode including an electroconductive material.

The electronic instruments may basically be any ones and include portable instruments and stationary instruments. Specific examples thereof include digital cameras and camcorders or camera-integrated videos (a video camera and videocassette recorder combined in one unit).

Other configurations as described above may be adopted herein, unless contrary to properties thereof.

According to an embodiment of the present invention, an electron transferring protein having a photoelectric conversion capability and containing a metal, such as zinc cytochrome c, can be easily immobilized on or above a first electrode having an arbitrary surface such as a curved surface, by using a wet process. The electron transferring protein having a photoelectric conversion capability and containing a metal (hereinafter also briefly referred to as "electron transferring protein") can easily be obtained with minimum synthesis reactions by using a naturally-occurring protein as a raw material and can be easily obtained, in contrast to complicated chemical syntheses as in organic semiconductors. According to this configuration, the magnitude and/or polarity of a photoelectric current passing through the transducer can be changed by regulating at least one selected from the potential difference between the first electrode and the second electrode; the intensity of light to be applied to the electron transferring protein; and the wavelength of light to be applied to the electron transferring protein.

According to an embodiment of the present invention, a photoelectric transducer can be arranged on a curved surface having an arbitrary shape. An electron transferring protein having a photoelectric conversion capability and containing a metal is used as a photoelectric conversion material and can be easily configured even not through complicated chemical syntheses. Accordingly, there is provided a novel photoelectric transducer yielding, for example, a bidirectional photoelectric current. There are also provided a semiconductor device using the photoelectric transducer, and an electronic instrument using the photoelectric transducer in a receiver.

### BRIEF DESCRIPTION OF THE DRAWINGS

Embodiments of the present invention will be described in detail based on the following figures, wherein:
FIGS. 1A and 1B are schematic diagrams showing a molecular structure of zinc cytochrome c;
FIG. 2 is a schematic diagram showing a photoelectric transducer according to a first embodiment of the present invention;
FIG. 3 is a photograph sowing a drop-shaped gold electrode carrying zinc cytochrome c for use in the evaluation of a photoelectric transducer according to the first embodiment of the present invention;
FIG. 4 is a schematic diagram showing an evaluation system for evaluating a photoelectric transducer according to the first embodiment of the present invention;
FIG. 5 is a schematic diagram showing a result in evaluation of a photoelectric transducer according to the first embodiment of the present invention;
FIG. 6 is a schematic diagram showing another result in evaluation of a photoelectric transducer according to the first embodiment of the present invention;
FIG. 7 is a schematic diagram showing yet another result in evaluation of a photoelectric transducer according to the first embodiment of the present invention;
FIG. 8 is a schematic diagram showing another result in evaluation of a photoelectric transducer according to the first embodiment of the present invention;
FIG. 9 is a schematic diagram showing another result in evaluation of a photoelectric transducer according to the first embodiment of the present invention;
FIG. 10 is a schematic diagram showing still another result in evaluation of a photoelectric transducer according to the first embodiment of the present invention;
FIG. 11 is a schematic diagram showing a photoelectric transducer according to a second embodiment of the present invention;
FIG. 12 is a schematic diagram showing how a state transits and how an electron flows in a photoelectric transducer according to the second embodiment of the present invention;
FIG. 13 is a schematic diagram showing a photoelectric transducer according to a third embodiment of the present invention;
FIG. 14 is a schematic diagram showing a porous electrode material for use in an electrode on which zinc cytochrome c is to be immobilized in a photoelectric transducer according to a fourth embodiment of the present invention;
FIG. 15 is a schematic diagram showing a porous electrode material carrying immobilized zinc cytochrome c is immobilized in a photoelectric transducer according to the fourth embodiment of the present invention;
FIG. 16 is a cross-sectional view showing the skeleton of a porous electrode material carrying immobilized zinc cytochrome c in a photoelectric transducer according to the fourth embodiment of the present invention;
FIG. 17 is a circuit diagram showing a photoelectric detector according to a fifth embodiment of the present invention;
FIG. 18 is a plan view showing a structure of a photoelectric detector according to the fifth embodiment of the present invention;
FIG. 19 is a cross-sectional view showing a structure of a photoelectric detector according to the fifth embodiment of the present invention;
FIG. 20 is a cross-sectional view showing another structure of a photoelectric detector according to the fifth embodiment of the present invention;
FIG. 21 is a cross-sectional view showing a charge-coupled device (CCD) image sensor according to a sixth embodiment of the present invention;
FIG. 22 is a circuit diagram showing an inverter circuit according to a seventh embodiment of the present invention; and
FIG. 23 is a circuit diagram showing a structure of an inverter circuit according to the seventh embodiment of the present invention.

### DESCRIPTION OF THE PREFERRED EMBODIMENTS

Some embodiments of the present invention will be illustrated in detail below, with reference to the attached drawings.

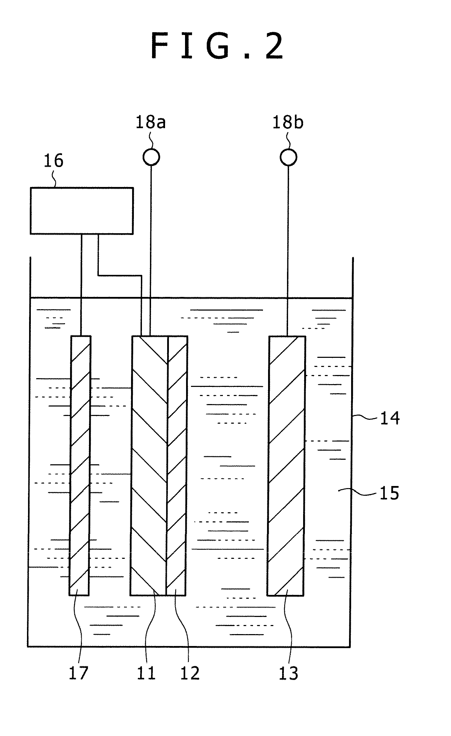

FIG. 2 shows a photoelectric transducer according to a first embodiment of the present invention. With reference to FIG. 2, the photoelectric transducer includes an electrode 11 and a monomolecular film or multilayer film of an electron transferring protein 12 immobilized on or above the electrode 11 directly or indirectly with the interposition of an intermediate layer. The electrode 11 includes an electroconductive material. The electron transferring protein 12 has a photoelectric conversion capability and contains a metal. The electrode 11 is illustrated as having a flat surface in FIG. 2. However, the surface of the electrode 11 can be of any shape such as a concave surface, convex surface, or convex-concave surface. An electrode 13 including an electroconductive material is arranged so as to face, with a spacing, the monomolecular film or multilayer film of electron transferring protein 12 immobilized on or above the electrode 11. These electrodes 11 and 13 are immersed in an electrolytic solution 15 in a housing 14. The electrolytic solution 15 may be one which does not adversely affect functions or capabilities of the electron transferring protein 12. An electrolyte or redox species of the electrolytic solution 15 may be one undergoing an oxidation reaction in the electrode 11 and a reducing reaction in the electrode 13, or one undergoing a reducing reaction in the electrode 11 and an oxidation reaction in the electrode 13.

Photoelectric conversion using the photoelectric transducer may be carried out in the following manner. A bias power supply 16 applies a bias voltage to the electrode 11 with respect to a reference electrode 17. In this state, light is applied to the electron transferring protein 12 immobilized on or above the electrode 11. The light has a wavelength that enables optical excitation of the electron transferring protein 12. The light may generally include visible rays. According to this configuration, the magnitude and/or polarity of a photoelectric current passing through the transducer can be varied by regulating at least one parameter selected from the bias voltage applied to the electrode 11; the intensity of the applied light; and the wavelength of the applied light. The photoelectric current is taken out from terminals 18a and 18b.

Above-listed electron transferring proteins can be used as the electron transferring protein 12.

Electroconductive materials for constituting the electrodes 11 and 13 can be those mentioned above and can be selected appropriately according to necessity. Specific examples thereof include inorganic materials typified by metals such as gold, platinum, and silver, and metal oxides or glass such as indium tin multicomponent oxide (ITO), fluorine-doped tin oxide (FTO), and Nesa glass (SnO₂ glass); electroconductive polymers such as polythiophenes, polypyrroles, polyacetylenes, polydiacetylenes, poly-p-phenylenes, and poly(p-phenylene sulfide)s; and tetrathiafulvalene-tetracyano-quinodimethane (TTF-TCNQ) and other charge transferring complexes containing tetrathiafulvalene derivatives such as tetrathiafulvalene (TTF), tetramethyl-tetraselena-fulvalene (TMTSF), and bisethylene-dithia-tetrathiafulvalene (BEDT-TTF). At least one of the electrodes 11 and 13 preferably includes an electroconductive material transparent to light, such as visible rays, for use in the optical excitation of the electron transferring protein 12. Examples of such transparent electroconductive materials include ITO, FTO, and Nesa glass. By satisfying this, light may be applied to the entire or substantially entire electron transferring protein 12 immobilized on or above the electrode 11. Embodiments

### 1. Preparation of sample

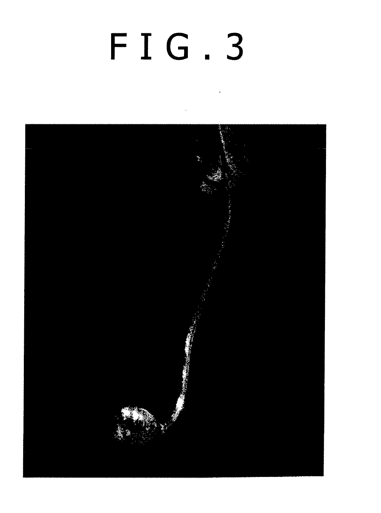

One end of a high-purity gold wire was melted to a drop-shaped article having a diameter of several millimeters. This was used as an electrode 11. The drop-shaped gold was immersed in an ethanol solution of 10-carboxy-1-decanethiol (HS(CH₂)₁₀COOH) to thereby yield a self-organized monomolecular film (self-assembled monolayer, SAM) of HS(CH₂)₁₀COOH as an intermediate layer on the drop-shaped gold. The resulting SAM electrode was immersed in a 10 mM solution of zinc cytochrome c in Tris-HCI buffer (pH 8.0) to thereby yield a SAM electrode having a two-layer structure including HS(CH₂)₁₀COOH and zinc cytochrome c adsorbed by the drop-shaped gold. Hereinafter the SAM electrode having the two-layer structure is also referred to as "zinc cytochrome c electrode". The zinc cytochrome c electrode is shown in FIG. 3. The preparation of zinc cytochrome c was carried out according to the above-mentioned technique described in Chem. Eur. J. 9, 3867-3875 (2003). The preparation of the zinc cytochrome c electrode was conducted following the technique for preparing an iron cytochrome c electrode descried by Jeong-Woo Choi and Masamichi Fujihira in Appl. Phys. Lett. 84, 2187-2189 (2004).

### 2. Preparation of determination

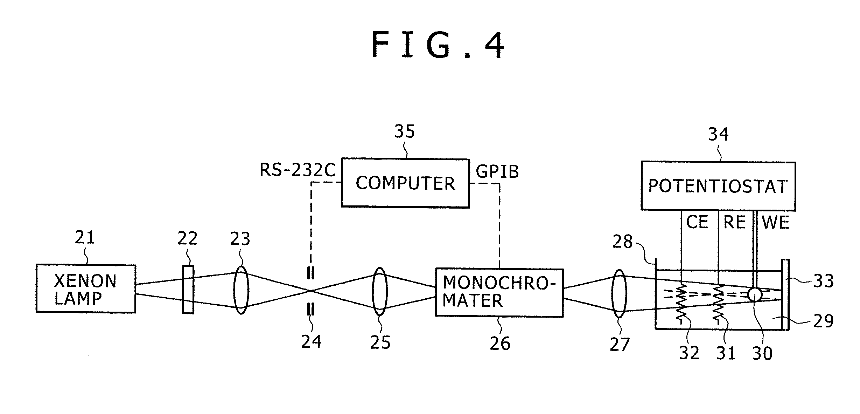

An optical experimental system was prepared. The system was so configured as to apply a monochromatic light to the entire surface of zinc cytochrome c electrode and to control the timing of light application by opening and closing a shutter. The zinc cytochrome c electrode as a working electrode, a silver wire as a reference electrode, and a platinum wire as a counter electrode were connected to a potentiostat. These electrodes were then immersed in an aqueous 10 mM phosphate buffer solution (pH 7.0) containing 2.5 mM K₄[Fe(CN)₆]. The experimental system is shown in FIG. 4. The system shown in FIG. 4 includes a xenon (Xe) lamp 21 as a light source (150 W), a cold filter 22, a condensing lens 23, a shutter 24 configured to control the passing of light (0.5 Hz), a condensing lens 25, a monochromator 26, a condensing lens 27, a housing 28, an aqueous phosphate buffer solution 29 containing K₄[Fe(CN)₆], a zinc cytochrome c electrode 30 as a working electrode, a silver wire 31 as a reference electrode, a platinum wire 32 as a counter electrode, an aluminum mirror 33, and a potentiostat 34. The cold filter 22 is configured to transmit visible rays efficiently and reflect heat rays among rays emitted from the xenon lamp 21. The monochromator 26 is configured to convert light passed through the shutter 24 into a monochromic ray having a desired wavelength. The aluminum mirror 33 is configured to reflect the ray monochromated by the monochromator 26. A computer 35 is configured to control the opening/closing of the shutter 24, and the wavelength of a ray to be monochromated by the monochromator 26.

### 3. Observation of photoelectric current

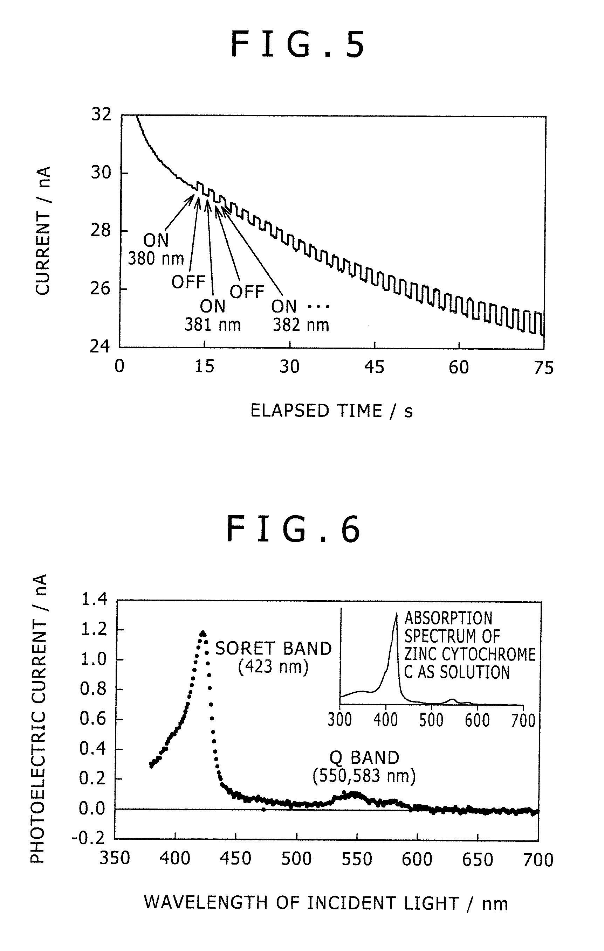

A bias voltage at +313 mV with respect to the silver wire 31 was applied to the zinc cytochrome c electrode 30 while keeping the shutter 24 closed, and the zinc cytochrome c electrode 30 was held in this state for sixty seconds. In this procedure, a dark current gradually decreased. Next, the shutter 24 was opened, and light at a wavelength of 380 nm was applied for one second, the shutter 24 was closed again, and the light irradiation was paused for one second. The wavelength of light to be applied was then swept or scanned by 1 nm by repeating application and pausing of light every one second in such a manner that light at a wavelength of 381 nm was applied for one second, the irradiation was paused for one second, light at a wavelength of 382 nm was applied for one second, and the irradiation was paused for one second. How a current varies with time in such an intermittent light irradiation process was observed. As a result, there was observed a pulsed change in current synchronizing to on/off of the light irradiation, i.e., a photoelectric current. The result is shown in FIG. 5.

An average of a width of rise and a width of fall was determined in each of pulses observed in the above determination. The average was defined as a photoelectric current at a wavelength. The values of photoelectric current at individual wavelengths were plotted and thereby yielded a photoelectric current action spectrum (FIG. 6). The resulting photoelectric current action spectrum is a similar figure to the absorption spectrum of zinc cytochrome c. This demonstrates that the photoelectric current occurs accompanying optical excitation of zinc cytochrome c.

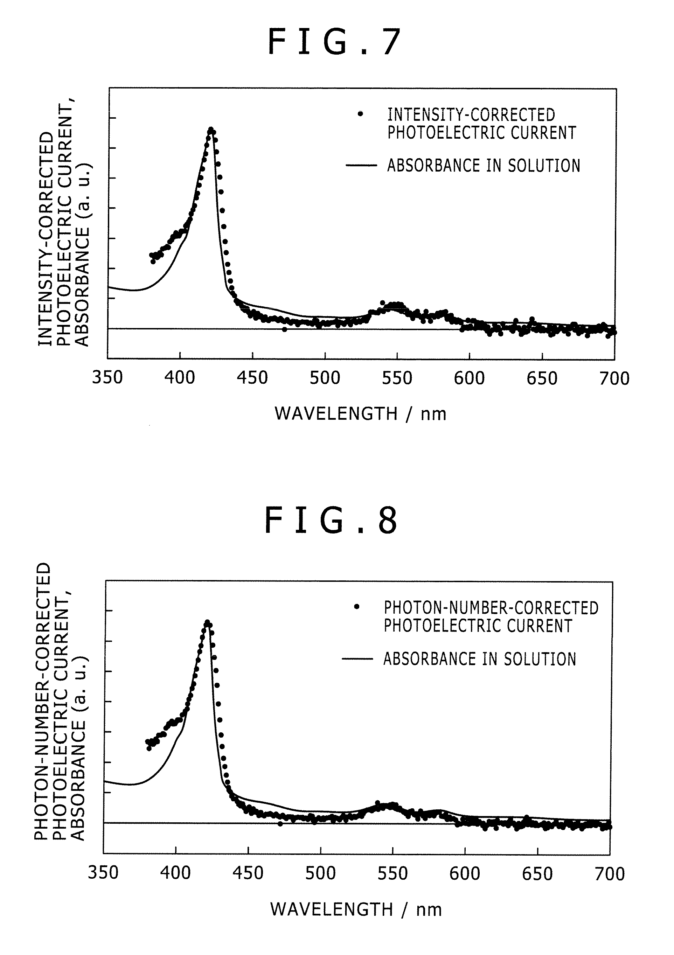

FIG. 7 shows an intensity-corrected photoelectric current action spectrum assuming that the intensity of incident light is constant. FIG. 8 shows a photon number-corrected photoelectric current action spectrum assuming that the number of incident photons is constant.

### 4. Control of polarity and magnitude of photoelectric current

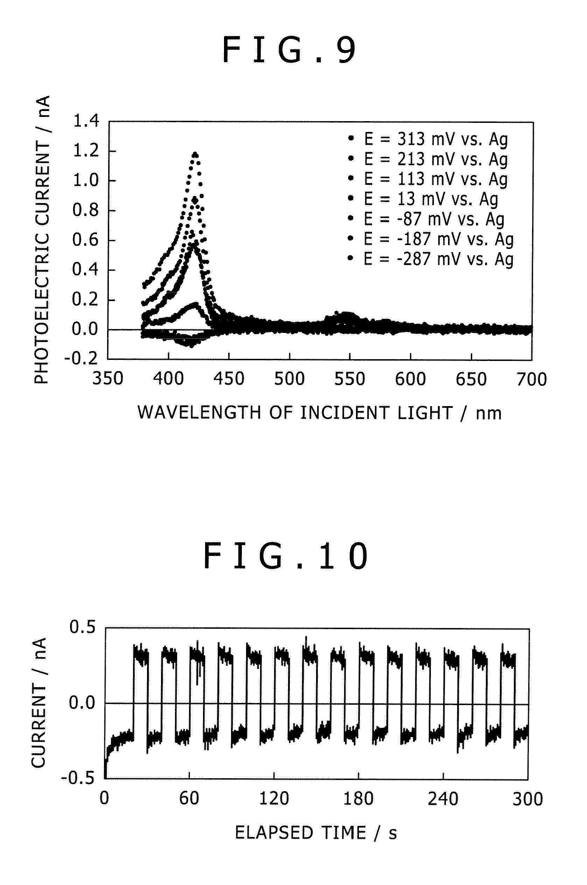

FIG. 9 demonstrates that both the polarity (direction of flow) and the magnitude of a photoelectric current can be controlled by regulating a bias voltage to be applied to the zinc cytochrome c electrode 30.

### 5. Polarity reversal of stationary electric current upon irradiation with light

FIG. 10 demonstrates that the polarity of the current can be reversed by application of light while setting a bias voltage to be applied to the zinc cytochrome c electrode 30 to such a bias voltage as to yield a very weak negative current in a dark place. The bias voltage in this experiment is a voltage of +23 mV with respect to the silver wire.

As is described above, according to the first embodiment, there is provided a novel photoelectric transducer using an electron transferring protein 12, such as zinc cytochrome c, as a photoelectric conversion material. This photoelectric transducer can yield a varied magnitude and/or polarity of a photoelectric current passing through the transducer by regulating at least one of the bias voltage to be applied to the electrode 11, the intensity of light to be applied, and the wavelength of light to be applied. The photoelectric transducer can therefore be applied to a variety of uses. The electron transferring protein 12 can be easily synthetically prepared, in contrast to complicated chemical syntheses as in organic semiconductors. It is therefore advantageous in the production of photoelectric transducers. In addition, the electrode 11 can have an arbitrary surface shape, and the structure of a photoelectric transducer can be designed with a high degree of freedom.

Next, a photoelectric transducer according to a second embodiment of the present invention will be illustrated. This photoelectric transducer is configured to be operated in an electrolytic solution, as in the photoelectric transducer according to the first embodiment.

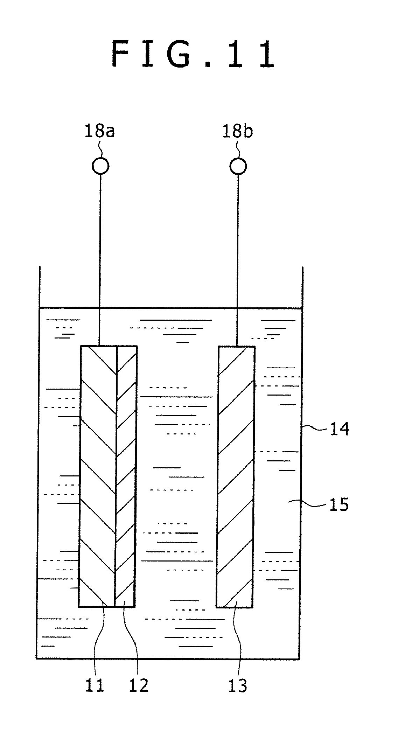

FIG. 11 shows the photoelectric transducer. With reference to FIG. 11, the photoelectric transducer uses, as a bias voltage, the difference in spontaneous electrode potential between electrodes 11 and 13. In contrast, the above-mentioned photoelectric transducer according to the first embodiment uses a bias voltage generated by the action of the bias power supply 16. The photoelectric transducer according to this embodiment may not include a reference electrode 17 and may be a two-electrode system using the electrodes 11 and 13.

Other configurations are the same as the first embodiment.

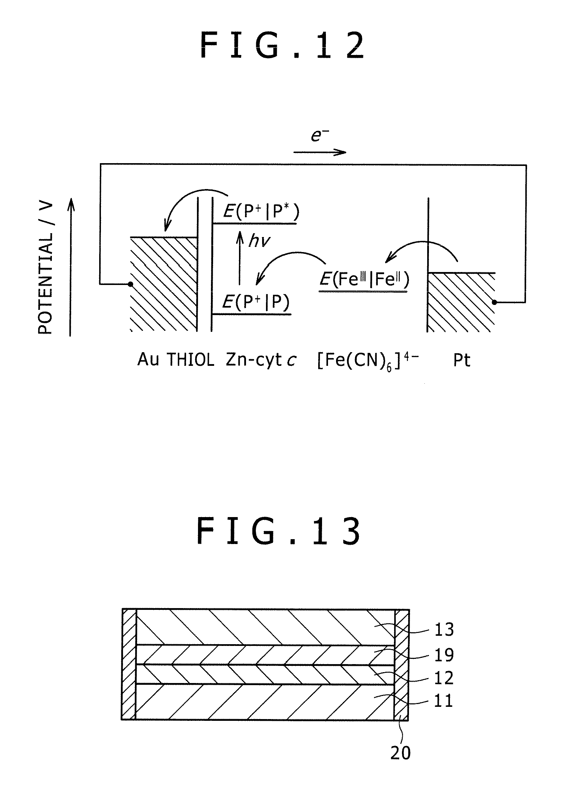

The determination of a photoelectric current of the photoelectric transducer was carried out by the above procedure, except for not using a silver wire 31 as a reference electrode. The determined photoelectric current action spectrum shows a Soret band and a Q-band as above, indicating that the observed photoelectric current is one accompanying optical excitation of zinc cytochrome c. FIG. 12 is a schematic diagram showing how a state transits and how an electron flows in the photoelectric transducer having a two-electrode system. The symbol "P" in FIG. 12 indicates zinc cytochrome c.

The determination of a photoelectric current was carried out by the procedure of the above-mentioned experiment, except for using no silver wire 31 as a reference electrode and using an ITO substrate as a counter electrode instead of the platinum wire 32. The determined photoelectric current action spectrum shows a Soret band and a Q-band as above, indicating that the observed photoelectric current is one accompanying optical excitation of zinc cytochrome c.

According to the second embodiment, same advantages as the first embodiment can be obtained.

Next, a photoelectric transducer according to a third embodiment of the present invention will be illustrated. This photoelectric transducer is configured to work even in a dry condition. In contrast, the photoelectric transducers according to above embodiments are configured to work in a solution.

FIG. 13 shows the photoelectric transducer. With reference to FIG. 13, the photoelectric transducer includes an electrode 11, and a monomolecular film or multilayer film of an electron transferring protein 12 immobilized on or above the electrode 11 directly or indirectly with the interposition of an intermediate layer. A solid electrolyte 19 is sandwiched between the monomolecular film or multilayer film of electron transferring protein 12 and an electrode 13. In addition, an encapsulant 20 is arranged so as to surround the solid electrolyte 19 in order to prevent the solid electrolyte 19 from drying. The solid electrolyte 19 includes a material which does not adversely affect functions or capabilities of the electron transferring protein 12. Specific examples of the solid electrolyte are agar and a polyacrylamide gel which do not adsorb a protein. At least one of the electrodes 11 and 13 may include an electroconductive material transparent to light for use in the optical excitation of the electron transferring protein 12. Such a transparent material includes ITO, FTO, and Nesa glass.

Photoelectric conversion using the photoelectric transducer is carried out in the following manner. Light is applied to the electron transferring protein 12 immobilized on or above the electrode 11 while using the difference in spontaneous electrode potential between the electrodes 11 and 13 as a bias voltage. The light has such a wavelength as to enable the optical excitation of the electron transferring protein 12. The magnitude and/or polarity of a photoelectric current passing inside the transducer can be varied by regulating at least one of the difference in spontaneous electrode potential between the electrodes 11 and 13, the intensity of the light to be applied, and the wavelength of the light to be applied.

Other configurations are the same as the first embodiment.

According to the third embodiment, similar advantages to the first embodiment can be obtained.

A photoelectric transducer according to a fourth embodiment of the present invention will be illustrated.

The photoelectric transducer has the same configuration as the above-mentioned photoelectric transducer, except for using a porous electroconductive material for an electrode 11.

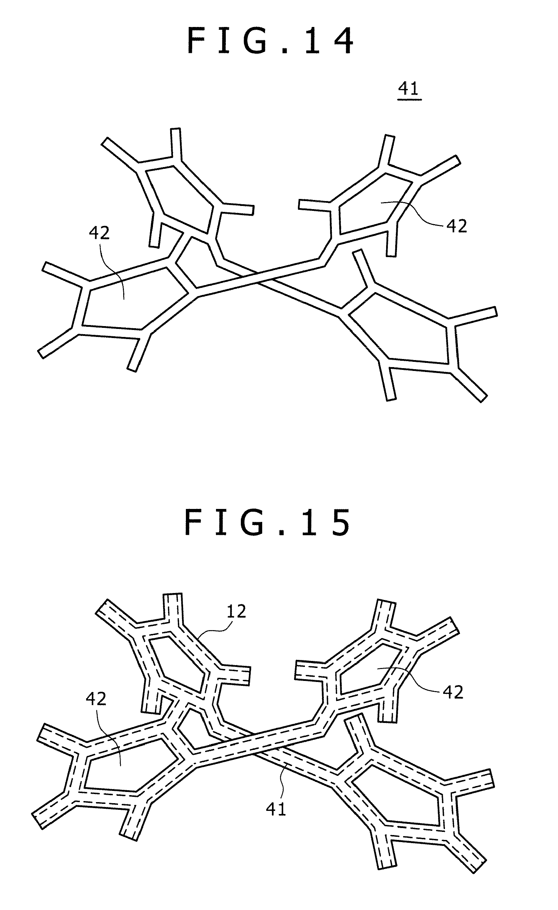

FIG. 14 schematically illustrates the structure of a porous electroconductive material 41 for use in a transducer. With reference to FIG. 14, the porous electroconductive material 41 has a three-dimensional network structure and includes many pores 42 corresponding to the network. These pores 42 may communicate with each other, but all the pores 42 may not necessarily always communicate with each other. The porous electroconductive material 41 preferably includes a foamed metal or foamed alloy, such as foamed nickel. The porous electroconductive material 41 has a porosity of generally about 80% or more, and more generally about 90% or more. The pores 42 have diameters of generally about 10 nm to about 1 mm, more generally about 10 nm to about 600 µm, further generally about 1 to about 600 µm, typically about 30 to about 400 µm, and more typically about 80 to about 230 µm. These parameters, however, are not limited to the values specified above.

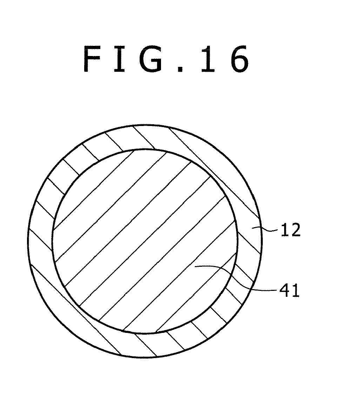

With reference to FIG. 15, a monomolecular film or multilayer film of an electron transferring protein 12 is immobilized on or above the porous electroconductive material 41 directly or indirectly with the interposition of an intermediate layer. FIG. 16 is a cross-sectional view of the skeleton of the porous electroconductive material 41 in this state.

According to the fourth embodiment, a porous electroconductive material 41 typically including a foamed metal or foamed alloy has pores 42 with sufficiently large diameters and thereby constitutes a loose three-dimensional network structure. The porous electroconductive material 41 exhibits a high strength, a high electroconductivity and has a sufficiently large surface area. Accordingly, when the porous electroconductive material 41 constitutes an electrode 11, and a monomolecular film or multilayer film of an electron transferring protein 12 is immobilized on or above the porous electroconductive material 41, the electron transferring protein 12 is three-dimensionally immobilized at a high density. The resulting photoelectric transducer may therefore have a significantly improved photoelectric conversion efficiency, in addition to advantages as mentioned above.

Next, a photoelectric detector according to a fifth embodiment of the present invention will be illustrated below.

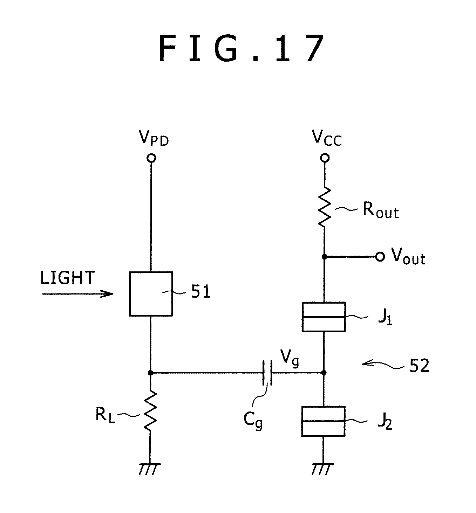

FIG. 17 is a circuit diagram showing the photoelectric detector. With reference to FIG. 17, the photoelectric detector includes a photodiode 51 and a single-electron transistor 52. The photodiode 51 includes a photoelectric transducer according to any of the first to fourth embodiments of the present invention. The single-electron transistor 52 is configured to amplify an output of the photodiode 51. The single-electron transistor 52 includes a drain micro tunneling junction J₁ and a source micro tunneling junction J₂. The micro tunneling junctions J₁ and J₂ have capacitances C₁ and C₂, respectively. For example, the photodiode 51 has an electrode 13 grounded through a load resistance R_{L} and has an electrode 11 connected to a positive power supply. The positive power supply is configured to supply a positive voltage V_{PD} for biasing the photodiode 52. The single-electron transistor 52 includes a grounded source and has a drain connected through an output resistance Rₒᵤₜ to a positive power supply. The positive power supply herein is configured to supply a positive voltage V_{CC}. The electrode 13 of the photodiode 51 is connected through a capacitor C_{g} to the gate of the single-electron transistor 52.

In the photoelectric detector having such a configuration, a photoelectric current passes therethrough upon irradiation of the photodiode 51 with light. Then, the capacitor C_{g} is charged by the action of a voltage occurring at both ends of the load resistance R_{L}. As a result, a gate voltage V_{g} is applied through the capacitor C_{g} to the gate of the single-electron transistor 52. A change ΔQ in electric charge accumulated in the capacitor C_{g} [ΔQ = C_{g}ΔV_{g}] is then measured, so as to determined the change ΔV_{g} of the gate voltage V_{g}. The single-electron transistor 52 is used for amplifying the output of the photodiode 51 and can detect the change ΔQ in electric charge accumulated in the capacitor C_{g} [ΔQ = C_{g}ΔV_{g}] with a sensitivity, for example, one million times as large as that of transistors in related art. Specifically, the single-electron transistor 52 can detect a minute change ΔV_{g} in gate voltage V_{g} and thereby contributes to reducing the load resistance R_{L}. The photoelectric detector can thereby have a significantly increased sensitivity and can work at a significantly increased speed. In addition, noise occurring in the amplifier circuit may be reduced, because thermal noise in the single-electron transistor 52 can be reduced as a result of charging effect. The photoelectric detector consumes a very low power, because the single-electron transistor 52 uses a tunnel effect of only one electron in its fundamental operation.

The photodiode 51 and the single-electron transistor 52 are connected to each other through capacitive coupling in the photoelectric detector, as mentioned above. A voltage gain herein is given as C_{g}/C₁. Accordingly, an output voltage Vₒᵤₜ may be obtained at a sufficient intensity to drive a device connected subsequently to the photoelectric detector, by sufficiently reducing the capacitance C₁ of the micro tunneling junction J₁.

Next, a specific structure of a photoelectric detector according to the fifth embodiment will be illustrated.

The photoelectric detector herein includes a single-electron transistor 52 and a photodiode 51. The single-electron transistor 52 has a metal/insulator junction. The photodiode 51 includes a photoelectric transducer according to the second embodiment of the present invention.

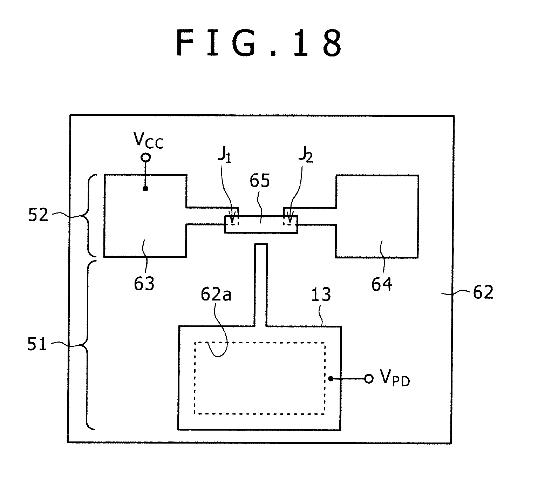

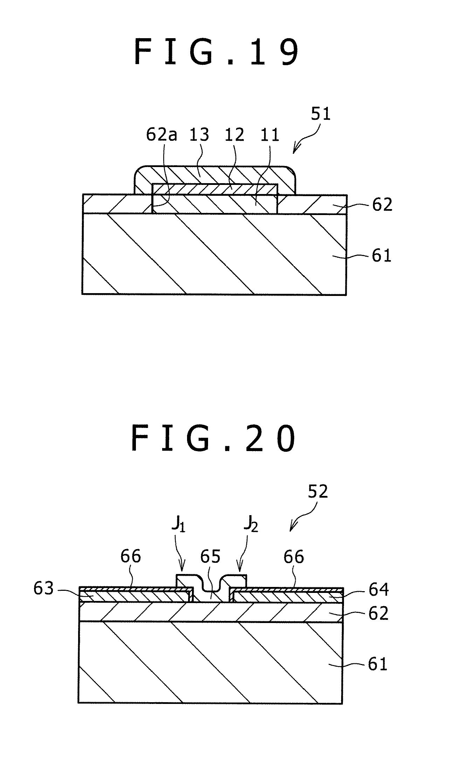

FIG. 18 is a plan view of the photoelectric detector. FIGS. 19 and 20 are a partially cross-sectional view of the photodiode 51 and a partially cross-sectional view of the single-electron transistor 52, respectively, in the photoelectric detector.

With reference to FIGS. 18, 19, and 20, the photoelectric detector includes a substrate 61 such as a semiconductor substrate, and an insulating film 62 arranged on the substrate 61. The insulating film 62 may be, for example, a silicon dioxide (SiO₂) film, a silicon nitride (SiN) film, or a polyimide film. The insulating film 62 has an opening 62a in a region under the photodiode 51. An electrode 11 is arranged on the substrate 61 exposed inside the opening 62a. A monomolecular film of an electron transferring protein 12 is immobilized on or above the electrode 11 directly or indirectly, and an electrode 13 is arranged on or above the electron transferring protein 12. In this structure, light is received after passing through the electrode 13. The electrode 13 is therefore configured to be transparent to light for use in the optical excitation of the electron transferring protein 12.

A source electrode 63 and a drain electrode 64 are arranged so as to face each other in the single-electron transistor 52 on the insulating film 62. A gate electrode 65 is arranged so as to partially overlie one end of the source electrode 63 and one end of the drain electrode 64, respectively. An insulating film 66 is arranged on the source electrode 63 and the drain electrode 64 at least in a region where the gate electrode 65 overlies. The insulating film 66 has a thickness of about a few tenths of a nanometer to several nanometers. The gate electrode 65 partially overlies one end of the source electrode 63 and one end of the drain electrode 64 with the interposition of the insulating film 66. The overlaid portions each have a size of typically about several hundreds of nanometers by several hundreds of nanometers. The portions where the gate electrode 65 overlies the source electrode 63 and the drain electrode 64 correspond to the micro tunneling junctions J₁ and J₂, respectively, in FIGS. 15 and 16. The gate electrode 65, the source electrode 63, and the drain electrode 64 may each include a metal such as aluminum (Al), indium (In), niobium (Nb), gold (Au), or (Pt).

In addition, a passivation film (not shown) may be arranged overall so as to cover the photodiode 51 and the single-electron transistor 52.

In this configuration, one end of the electrode 13 of the photodiode 51 lies in the vicinity of the gate electrode 65 of the single-electron transistor 52. When a passivation film is not arranged, there is formed a capacitor structurally including an air layer sandwiched between an end of the electrode 13 and the gate electrode 65. This constitutes a capacitive coupling between the electrode 13 and the gate electrode 65. When a passivation film is arranged, there is formed a capacitor structurally including the passivation film sandwiched between an end of the electrode 13 and the gate electrode 65. This constitutes a capacitive coupling between the electrode 13 and the gate electrode 65.

A photoelectric detector as mentioned above is configured so that a single-electron transistor 52 amplifies an output of a photodiode 51. This photoelectric detector can carry out photoelectric detection at a higher speed with a higher sensitivity and consume a less power than photoelectric detectors in related art using a regular transistor for the amplification of the output of a photodiode.

Next, a CCD image sensor according to a sixth embodiment of the present invention will be illustrated. The CCD image sensor is of an interline transfer system including a receiver, a vertical resistor, and a horizontal resistor.

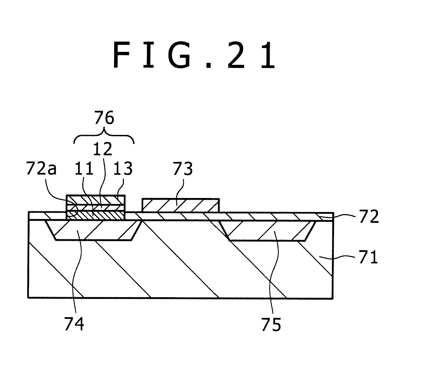

FIG. 21 shows a cross-sectional structure of a receiver, and a vertical resistor in the vicinity of the receiver in the CCD image sensor. With reference to FIG. 21, a gate insulator 72 is arranged on a p-type silicon substrate 71 or on a p-well layer arranged on an n-type silicon substrate. A read gate electrode 73 is arranged on the gate insulator 72. An n-type layer 74 and another n-type layer 75 are arranged in the p-type silicon substrate 71 at both sides of the read gate electrode 73. The n-type layer 75 constitutes a vertical resistor. The gate insulator 72 has an opening 72a in a region over the n-type layer 74. A photoelectric transducer according to the third embodiment of the present invention is arranged as a receiver 76 on the n-type layer 74 within the opening 72a. Other configurations of the CCD image sensor may be the same as CCD image sensors of an interline transfer system in related art.

The CCD image sensor may be configured as follows. The electrode 11 of the photoelectric transducer is biased. The bias voltage herein is positive with respect to the electrode 13. When light enters the electron transferring protein 12 of the receiver 76, an electron is formed as a result of optical excitation and flows into the n-type layer 74. Next, a positive voltage is applied to the read gate electrode 73 while applying a voltage to the n-type layer 75 constituting the vertical resistor, which voltage is higher than that of the n-type layer 74. This yields an n-type channel in the p-type silicon substrate 71 directly below the read gate electrode 73. An electron of the n-type layer 74 is read out through the n-type channel to the n-type layer 75. The read charge is transferred in the vertical resistor and then transferred in the horizontal resistor, and an electric signal corresponding to an imaged picture is taken out from an output terminal.

According to the sixth embodiment, there is provided a novel CCD image sensor using an electron transferring protein 12 as a receiver 76.

An inverter circuit according to a seventh embodiment of the present invention will be illustrated below.

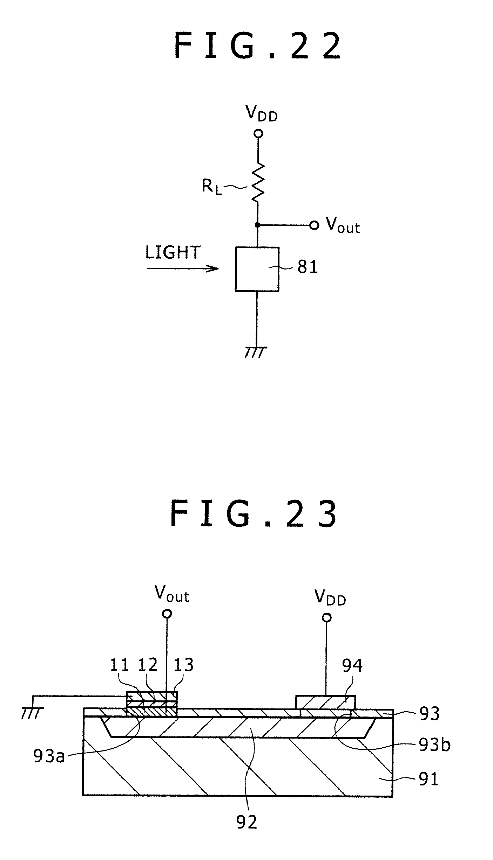

The inverter circuit is shown in FIG. 22. With reference to FIG. 22, the inverter circuit includes a photoelectric transducer 81 and a load resistance R_{L} connected in series to each other. The photoelectric transducer 81 has a similar configuration to a photoelectric transducer according to any of the first to fourth embodiments of the present invention. The load resistance R_{L} is connected to an electrode 11 of the photoelectric transducer 81. A predetermined positive power supply voltage V_{DD} is applied to an end of the load resistance R_{L}, and an electrode 13 of the photoelectric transducer 81 is grounded. When a signal light such as visible ray is applied to an electron transferring protein 12 of the photoelectric transducer 81, the photoelectric transducer 81 is turned on so as to allow a photoelectric current to pass therethrough. As a result, an output voltage Vₒᵤₜ from the electrode 11 decreases. When the light application is paused, the photoelectric transducer 81 is turned off so that a photoelectric current is stopped. As a result, the output voltage Vₒᵤₜ from the electrode 11 increases.

The inverter circuit may have, for example, a structure shown in FIG. 23. With reference to FIG. 23, the inverter circuit includes an n-type layer 92 arranged in a p-type silicon substrate 91 or in a p-well layer arranged on an n-type silicon substrate. The n-type layer 92 serves as a load resistance R_{L}. An insulating film 93, such as a SiO₂ film, is arranged on the p-type silicon substrate 91. The insulating film 93 has openings 93a and 93b at both ends of the n-type layer 92, respectively. A photoelectric transducer 81 is arranged on the n-type layer 92 exposed inside the opening 93a. An electrode 94 establishes an Ohmic contact with the n-type layer 92 through the opening 93b. Where necessary, the p-type silicon substrate 91 may further include one or more other electronic circuits that can be operated by the action of an output voltage Vₒᵤₜ, such as amplifier circuits, in addition to the inverter circuit.

According to the seventh embodiment, there is provided an inverter circuit including a load resistance R_{L} and a photoelectric transducer 81 using an electron transferring protein 12. Using the inverter circuit, various circuits such as arithmetic circuits can be configured.

While preferred embodiments have been described, it should be understood by those skilled in the art that various modifications, combinations, subcombinations, and alterations may occur depending on design requirements and other factors insofar as they are within the scope of the appended claims or the equivalents thereof.

For example, parameters, structures, configurations, dimensions, materials, and other conditions described above should be taken only by example, and any other parameters, structures, configurations, dimensions, materials, and other conditions can be employed according to necessity.

## Claims

1. A photoelectric transducer comprising:
a first electrode (11) including an electroconductive material;
zinc cytochrome c, a derivative thereof, or a mutant of them immobilized on or above the first electrode (11); and
a second electrode (13) including an electroconductive material.

2. The photoelectric transducer according to Claim 1, wherein the zinc cytochrome c, a derivative thereof, or a mutant of them immobilized on or above the first electrode (11) is in the form of a monomolecular film or multilayer film (12).

3. The photoelectric transducer according to Claim 1, wherein the second electrode (13) is arranged so as to face, at a spacing, the zinc cytochrome c, a derivative thereof, or a mutant of them immobilized on or above the first electrode (11), and wherein the first electrode (11) and the second electrode (13) are immersed in an electrolytic solution (15).

4. The photoelectric transducer according to Claim 1, wherein at least one of the first electrode (11) and the second electrode (13) is transparent to visible rays.

5. The photoelectric transducer according to Claim 1, further comprising a solid electrolyte (19) arranged between the second electrode (13) and the zinc cytochrome c, a derivative thereof, or a mutant of them immobilized on or above the first electrode (11).

6. The photoelectric transducer according to Claim 5, wherein the solid electrolyte (19) is a solid electrolyte which does not adsorb the zinc cytochrome c, a derivative thereof, or a mutant of them.

7. The photoelectric transducer according to Claim 1, wherein the transducer is configured to vary the magnitude and/or polarity of a photoelectric current passing through the transducer by regulating at least one selected from:
the potential difference between the first electrode (11) and the second electrode (13);
the intensity of light to be applied to the zinc cytochrome c, a derivative thereof, or a mutant of them; and
the wavelength of light to be applied to the zinc cytochrome c, a derivative thereof, or a mutant of them.

8. A semiconductor device comprising a photoelectric transducer, the photoelectric transducer including:
a first electrode (11) including an electroconductive material;
zinc cytochrome c, a derivative thereof, or a mutant of them immobilized on or above the first electrode (11); and
a second electrode (13) including an electroconductive material.

9. A photoelectric transducer comprising:
a first electrode (11) including an electroconductive material;
an electron transferring protein (12) being immobilized on or above the first electrode (11), having a photoelectric conversion capability, and containing a metal; and
a second electrode (13) including an electroconductive material.

10. A semiconductor device comprising a photoelectric transducer, the photoelectric transducer including:
a first electrode (11) including an electroconductive material;
an electron transferring protein (12) being immobilized on or above the first electrode (11), having a photoelectric conversion capability, and containing a metal; and
a second electrode (13) including an electroconductive material.

11. An electronic instrument comprising one or more photoelectric transducers,
wherein at least one of the one or more photoelectric transducers is a photoelectric transducer including:
a first electrode (11) including an electroconductive material;
zinc cytochrome c, a derivative thereof, or a mutant of them immobilized on or above the first electrode (11); and
a second electrode (13) including an electroconductive material.

12. An electronic instrument comprising one or more photoelectric transducers,
wherein at least one of the one or more photoelectric transducers is a photoelectric transducer including:
a first electrode (11) including an electroconductive material;
an electron transferring protein (12) being immobilized on or above the first electrode (11), having a photoelectric conversion capability, and containing a metal; and
a second electrode (13) including an electroconductive material.
